# Europäisches Patentamt

**European Patent Office**

**Office européen des brevets**

(11) Numéro de publication: **0 099 814**
**B1**

(12) **FASCICULE DE BREVET EUROPÉEN**

(45) Date de publication du fascicule du brevet:
08.04.87

(21) Numéro de dépôt: **83401422.7**

(22) Date de dépôt: **08.07.83**

�mil_Int. Cl.⁴: **H 04 L 7/02,** H 03 L 7/14

(54) Dispositif de récupération de fréquence d'horloge adapté aux radiocommunications à haute fréquence en milieux pertubés.

(30) Priorité: **23.07.82 FR 8212904**

(43) Date de publication de la demande:
**01.02.84 Bulletin 84/5**

(45) Mention de la délivrance du brevet:
**08.04.87 Bulletin 87/15**

(84) Etats contractants désignés:
**DE GB IT NL SE**

(56) Documents cité:
**FR-A-2 019 717**
**US-A-3 462 551**
**US-A-4 326 173**

(73) Titulaire: **THOMSON- CSF, 173, Boulevard Haussmann, F-75379 Paris Cedex 08 (FR)**

(72) Inventeur: **Pinsard, Hervé, THOMSON- CSF SCPI 173, bld. Haussmann, F-75379 Paris Cedex 08 (FR)**
Inventeur: **Collin, Claude, THOMSON- CSF SCPI 173, bld. Haussmann, F-75379 Paris Cedex 08 (FR)**
Inventeur: **Faydit, Joel, THOMSON- CSF SCPI 173, bld. Haussmann, F-75379 Paris Cedex 08 (FR)**

(74) Mandataire: **Weinmiller, Jürgen, Lennéstrasse 9 Postfach 24, D-8133 Feldafing (DE)**

## Description

La présente invention se rapporte à la transmission d'informations numeriques en milieux perturbés et concerne un dispositif de récupération de fréquence horloge utilisé dans les équipements de transmission d'informations numériques entre deux stations terminales, en visibilité ou non, la liaison étant assurée le plus souvent par propagation troposphérique ou ionosphérique.

De telles liaisons présentent une atténuation de propagation très variable en fonction du temps. Pour assurer en permanence la transmission des informations, il n'est pas économiquement rentable et même, dans bien des cas, il est pratiquement impossible de mettre en oeuvre des equipements ayant une marge de transmission suffisante pour assurer une qualité de communication minimale lors d'une atténuation de propagation maximale, une telle atténuation n'étant rencontrée que pendant un très faible pourcentage de temps.

Pour résoudre cette difficulté, plusieurs voies de transmission en parallèle, dont les caractéristiques sont suffisamment distinctes pour ne pas être affectées simultanément par une même atténuation de propagation, sont constituées; on obtient ainsi un fonctionnement en diversité ou les signaux des différentes voies sont combinés, avec des pondérations automatiquement ajustées, afin d'obtenir à chaque instant une qualité au moins égale à celle de la voie présentant la meilleure qualité.

L'ordre de diversité employé étant limité, il subsiste des périodes de propagation difficiles, notamment en diffusion troposphérique ou ionosphérique, pendant lesquelles le signal démodulé et combiné est de qualité très dégradée. Pendant de brefs intervalles de temps (variables de quelques millisecondes à quelques secondes), le rapport signal à bruit obtenu est très faible et peut tendre vers zero.

Or ce signal démodulé et combiné de type analogique doit être régénéré sous forme numérique. Pour cela, il est aiguillé sur deux voies:
- une voie récupération d'horloge,
- et une voie régénération, celle-ci étant effectuée à partir de cette horloge récupérée.

Après régénération, l'équipement de transmission restitue les deux signaux qu'il a la charge de transmettre:

le train numérique contenant l'information
- l'horloge en phase avec ce train numérique.

Ces deux signaux sont exploités par l'équipement de traitement numerique (multiplexeur, calculateur;..), l'horloge etant généralement utilisée pour la synchronisation du traitement numérique.

Le bon fonctionnement de ces équipements d'exploitation, caractérisé par le maintien de leur synchronisme, va donc dépendre de la qualité et du maintien de l'horloge bit en présence d'évanouissements profonds dus à la propagation.

Ces évanouissements, se traduisent par l'apparition d'une gigue de phase sur l'horloge bit, laquelle au delà d'une certaine valeur, rend ce signal inexploitable.

Les dispositifs de récupération de fréquence horloge généralement utilisés ne sont pas optimisés pour un fonctionnement à très faible rapport signal à bruit et de plus, les circuits employés présentent fréquemment un effet de seuil en présence de bruit élevé.

La demande FR-A-2 019 717 décrit un récepteur pour signaux impulsionnels d'information situés dans une bande de transmission allouée dans lequel pour rétablir la fréquence d'horloge avec la phase correcte, à partir des signaux impulsionnels d'information, on applique un signal impulsionnel d'information multivalent, prélevé sur le dispositif de détection, à un circuit sélectif incorporé à l'extracteur de fréquence horloge et accordé sur la demi-fréquence d'horloge. Ce circuit sélectif dont la sortie est reliée à un circuit non linéaire remplissant la fonction de doubleur de fréquence, est relié, par l'intermédiaire d'un interrupteur électronique normalement ouvert, au circuit de synchronisation de phase du générateur local d'impulsions d'horloge. Cet interrupteur électronique est commandé par un circuit de commande auquel est appliqué un signal prélevé sur le circuit sélectif et auquel est incorporé un dispositif à seuil, qui lorsque la valeur de seuil est dépassée, fournit un signal de commande pour la fermeture de l'interrupteur électronique.

La présente invention a pour objet un dispositif de récupération de fréquence horloge, qui continue à fonctionner en présence d'évanouissements profonds, particulièrement adapté aux communications en haute fréquence.

Ce système est tel que:
- la fréquence horloge récupérée présente une gigue de phase négligeable;
- le maintien de l'horloge bit, en présence de coupures du signal reçu peut atteindre plusieurs secondes, le déphasage résultant étant inférieur à 1/4 de bit, afin que ce signal reste exploitable;
- le retour à la phase initiale lors de la réapparition du signal reçu est quasi-instantané.

L'invention propose un dispositif de récupération de fréquence d'horloge adapté aux radiocommunications à haute fréquence en milieux perturbés, comportant un circuit analogique de redressement du signal reçu, pour faire apparaître dans le signal une composante à la fréquence d'horloge, dont la sortie est reliée à un circuit de filtrage, un circuit de commutation, à deux positions fonction de la qualité de la liaison, et un circuit de sortie à la sortie duquel est disponible le signal d'horloge récupéré, le circuit de commutation reliant l'entrée du circuit de sortie à la sortie du circuit de filtrage lorsque la liaison est de bonne qualité, caractérisé en ce que le circuit de filtrage est un circuit à bande très étroite et en ce que le circuit de commutation relie l'entrée du circuit de sortie à sa propre sortie lorsque la liaison a un fort niveau de bruit, le décalage entre l'entrée et la sortie de ce circuit de sortie étant ajusté pour être égal à un nombre entier de périodes du signal d'horloge.

L' invention sera mieux comprise et d'autres caractéristiques apparaîtront à l'aide de la description ci-après en référence aux figures annexées.

- La figure 1 représente le dispositif de récupération de fréquence horloge suivant l'invention.

- La figure 2 est le schéma d'un mode de réalisation de la boucle de phase.

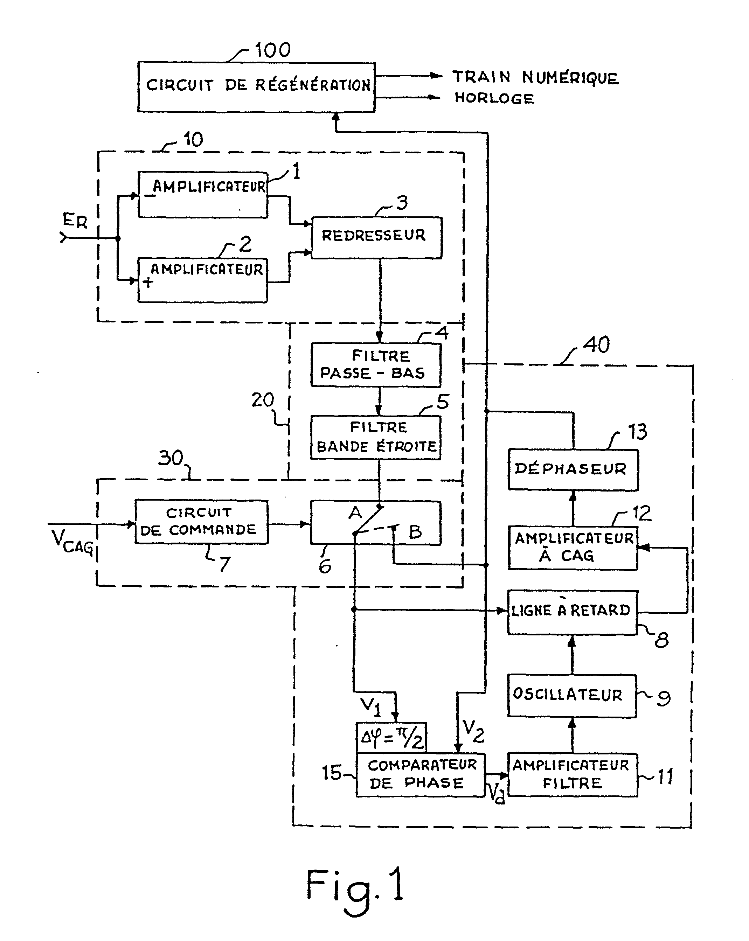

La figure 1 représente le dispositif de récupération d'horloge suivant l'invention. Il comporte une entrée de signal $E_R$, à laquelle est appliqué le signal démodulé et combiné résultant de la combinaison des signaux reçus dans plusieurs voies en diversité. Cette entrée est reliée à l'entrée d'un circuit de redressement 10 du signal reçu qui comporte deux amplificateurs linéaires 1 et 2 en parallèle ayant des sorties inversées reliées aux entrées d'un redresseur double alternance à diodes, 3.

Dans ce premier circuit les impulsions en forme de demi-sinusoïdes provenant du signal démodulé sont amplifiées puis redressées. Il apparaît ainsi de l'énergie à la fréquence du rythme numérique: par exemple pour un rythme numérique de 100 k bit/s, il apparaît de l'énergie à la fréquence f = 100 kHz. Contrairement aux circuits de mise en forme logiques, ce circuit ne présente pas d'effet de seuil. La sortie du redresseur 3 est reliée à un circuit de filtrage, 20, qui comporte un filtre passe-bas 4, dont la fréquence de coupure est légèrement supérieure à la fréquence d'horloge. Ce premier filtre permet d'éliminer les harmoniques de la fréquence d'horloge. La sortie de ce filtre passe-bas 4 est reliée à l'entrée d'un filtre passe-bande 5, de bande très étroite centrée sur la frequence d'horloge. Sa bande passante est de l'ordre de $10^{-4}$ de la frequence d'horloge. Par exemple, pour une fréquence d'horloge de 100 kHz la bande passante du filtre 5 est de l'ordre de 10 Hz. Ce filtrage très étroit permet une amélioration importante du rapport signal à bruit à la sortie. En effet, la puissance de bruit est intégrée dans une bande de 10 Hz seulement, au lieu du bruit dans la bande de 100 kHz existant à l'entrée du dispositif. Ce filtre peut être constitué par exemple d'un quartz utilisé à la résonance série, l'accord étant effectué par un condensateur ajustable série et la bande passante étant fixée par une résistance série. Le signal de sortie du filtre passe-bande 5 est donc un signal sinusoïdal sans gigue de phase notable pour les très faibles rapports signal à bruit. De plus lors d'une coupure du signal reçu, en cas d'évanouissement profond par exemple, le signal ne décroît que progressivement en sortie du filtre du fait de la constante de temps de ce filtre associée à sa bande passante très étroite.

En fonctionnement normal, c'est-à-dire lorsque le rapport signal à bruit ne descend pas au-dessous d'un seuil, ce signal sert de référence à une boucle de phase. Pour cela entre la sortie du circuit de filtrage 20 et l'entrée d'un circuit de sortie 40 à oscillateur à boucle de phase, est placé un circuit de commutation 30 qui comporte un inverseur à deux positions 6 permettant de commuter l'entrée du circuit 40 soit sur la sortie du circuit 20 (position A) soit sur la sortie du circuit 40 (position B). Cet inverseur est commandé par un circuit de commande logique 7. Ce circuit logique fonctionne à partir d'une information de qualité de la transmission proportionnelle au rapport signal à bruit instantané, par exemple la tension de commande automatique de gain de l'amplificateur en fréquence intermédiaire, $V_{CAG}$. Pour des valeurs du rapport signal à bruit supérieures à une valeur de référence fixée $(S/B)_0$, ce circuit logique place l'inverseur 6 en position A; pour des valeurs du rapport signal à bruit inférieures à $(S/B)_0$ l'inverseur passe à la position B.

L'entrée du circuit de sortie 40 est reliée à l'entrée d'une ligne à retard de type à transfert de charges, DTC 8, ayant une entrée d'horloge de décalage reliée à la sortie d'un oscillateur à quartz 9 (VCX0) asservi en phase, cet oscillateur ayant une fréquence égale ou voisine d'une fréquence multiple de la fréquence du signal d'horloge.

Pour la commande de phase de l'oscillateur 9, le circuit 40 comporte une boucle de phase comportant un comparateur de phase de type analogique 15 ayant un déphaseur $\pi/2$ sur l'une de ses entrées, dont la sortie est reliée à un amplificateur avec filtre de boucle 11. La sortie de cet amplificateur filtre est reliée à l'entrée de commande de phase de l'oscillateur 9. La sortie de la ligne à retard 8 est reliée à l'entrée d'un amplificateur à commande automatique de gain 12 délivrant, un signal de niveau constant. La sortie de cet amplificateur est reliée à un déphaseur 13 permettant de compenser le déphasage fixe entre les signaux d'entrée et de sortie du circuit 40, à 2 $\pi$ près. Lorsque la fréquence de l'oscillateur à quartz 9 n'est pas exactement égale à un multiple de la fréquence d'horloge, le déphasage 13 intègre le décalage fixe dû à cette différence de fréquence.

Ce circuit 40 délivre le signal d'horloge sous forme analogique sans gigue de phase notable. Cette information, après mise en forme, est utilisée pour la prise de décision dans le circuit de régénération 100 du train numérique.

Le fonctionnement de ce système est le suivant. La boucle de phase est caractérisée par sa fréquence de coupure, ou sa constante de temps.

Sa tension de sortie est de la forme:

$$Vd = a V_1 V_2 \cos \varphi$$

où V1 est la tension de sortie du filtre 5 à bande étroite lorsque l'inverseur est dans la position A et la tension de sortie du circuit 40 lorsque l'inverseur est dans la position B, où V2 est la tension de sortie du circuit 40, et où $\varphi$ est l'écart

de phase entre les deux tensions d'entrée du comparateur 15 augmenté du décalage fixe $\pi/2$ imposé sur l'une des entrées, la caractéristique du comparateur de phase étant telle que Vd = 0 lorsque $\varphi = \pi/2$, c'est-à-dire lorsque le décalage de phase entre les deux entrées est nul à 2k $\pi$ près. La ligne à retard 8 est caractérisée par son retard $\zeta = \frac{K}{F}$; F étant la fréquence de l'oscillateur 9 et K une constante caractéristique de cette ligne. Lorsque la tension de sortie $V_1$ du circuit 30 est un signal analogique peu bruité de fréquence égale à la fréquence d'horloge f, l'inverseur 6 est en position A. La fréquence F de l'oscillateur est égale à $F_o$ telle que:

$\varphi = \frac{\pi}{2}$ et Vd = 0

La ligne à retard 8 agit alors uniquement pour introduire un retard et le signal d'horloge en sortie du circuit 40 est en phase à 2 k$\pi$ près avec le signal de référence à la sortie du circuit 30.

Lors d'un evanouissement profond, l'inverseur 6 passe en position B. A cet instant,

$\varphi = \frac{\pi}{2}$ Vd = 0

Le signal de référence n'est plus pris en compte pour la récupération du signal d'horloge, les deux entrées du comparateur de phase reçoivent toutes les deux le signal de sortie du circuit, et la ligne à retard bouclée sur elle-même agit comme un oscillateur dont la fréquence est égale à la fréquence d'horloge f puisque la condition de déphasage nul entre l'entrée et la sortie de la ligne est réalisée pour une fréquence horloge de commande égale à $F_o$.

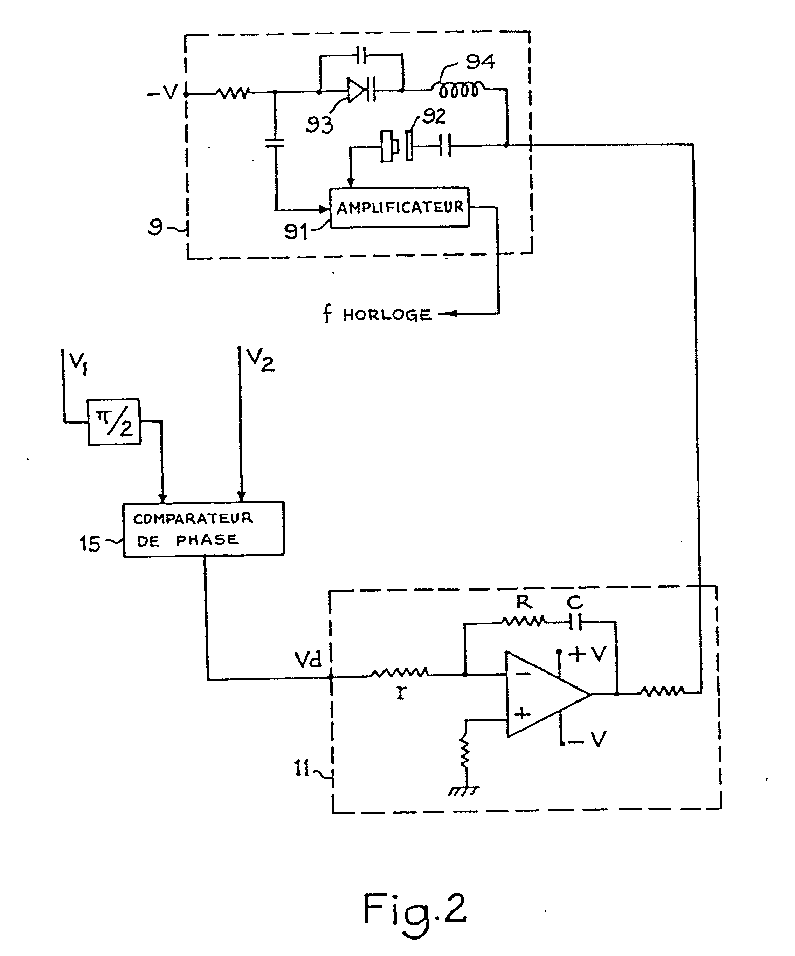

La figure 2 représente les détails d'un mode de réalisation de la boucle de phase.

L'oscillateur 9 comporte un amplificateur 91 associé à un quartz 92, sa commande de phase étant réalisée par un varactor 93, c'est-à-dire une diode polarisée en inverse par une tension d'alimentation -V dont la capacité varie avec la tension appliquée, en série avec une inductance 94. La tension appliquée au varactor commandant la fréquence de l'oscillateur 9 est la tension de sortie de l'amplificateur à filtre de boucle 11. L'amplificateur à filtre de boucle 11 est un amplificateur différentiel polarisé par les tensions d'alimentation -V et +V à l'entrée "moins" duquel est appliquée, par l'intermédiaire d'une résistance r, la tension d'erreur $V_d$, et dont la sortie est reliée à cette même entrée par un circuit à résistance R et condensateur C en série réalisant le filtre de boucle. Lors d'une coupure de la transmission, le signal de référence disparaît et les deux entrées du comparateur de phase reçoivent le même signal. La tension d'erreur Vd est nulle et l'asservissement de phase n'agit plus. Par contre, le condensateur C de forte valeur, plusieurs microfarads, se décharge à travers la diode varactor polarisée en inverse dont la résistance est très forte (plusieurs mégohms). La constante de temps de ce circuit est très élevée et la variation de la tension à la sortie de l'amplificateur différentiel reste négligeable sur quelques secondes; en conséquence la fréquence de l'oscillateur reste également stable et seule une faible dérive de phase en résulte et par conséquent une faible variation de phase en sortie de la ligne à retard 8.

Classiquement pour que les systèmes de traitement qui suivent un tel circuit de récupération fonctionnent convenablement, on impose généralement un déphasage de l'horloge bit inférieur à un quart de bit sur plusieurs secondes. Cette caractéristique peut être obtenue sans difficulté à l'aide du dispositif de recuperation suivant l'invention.

Lorsque le signal réapparaît après une coupure de la transmission, le signal de référence $V_1$ est présent. L'asservissement entre en action rapidement par suite du gain de boucle élevé (défini par le rapport R/r). La tension $V_d$ qui était très voisine de 0 volt lors de la coupure atteint la valeur a $V_1$ $V_2$ Cos $\varphi$ sans discontinuité de tension. Il en résulte que la fréquence F revient à sa valeur nominale $F_o$ sans discontinuite et que la phase du signal horloge revient à sa valeur nominale.

Ce dispositif permet donc à l'équipement de transmission de restituer l'horloge à l'équipement de traitement des informations numériques même lors de mauvaises conditions de propagation.

Ce dispositif s'applique comme indiqué ci-dessus à la transmission d'informations numériques en milieux fortement perturbés et donc surtout aux liaisons sans visibilité pour radiocommunications troposphériques ou ionosphériques et également aux radiocommunications à partir de véhicules mobiles.

**Revendications**

1/ Dispositif de récupération de fréquence d'horloge adapté aux radiocommunications à haute fréquence en milieux perturbés, comportant un circuit analogique (10) de redressement du signal reçu, pour faire apparaître dans le signal une composante à la fréquence d'horloge, dont la sortie est reliée à un circuit de filtrage (20), un circuit de commutation (30), à deux positions fonction de la qualité de la liaison, et un circuit de sortie (40) à la sortie duquel est disponible le signal d'horloge récupéré, le circuit de commutation (30) reliant l'entrée du circuit de sortie (40) à la sortie du circuit de filtrage (20) lorsque la liaison est de bonne qualité, caractérisé en ce que le circuit de filtrage (20) est un circuit à bande très étroite et en ce que le circuit de commutation (20) relie l'entrée du circuit de sortie à sa propre sortie lorsque la liaison a un fort niveau de bruit, le décalage entre l'entrée et la sortie de ce circuit de sortie étant ajusté pour être égal à un nombre entier de périodes du signal d'horloge.

2/ Dispositif selon la revendication 1, caractérisé en ce que le circuit de sortie (40) comporte en série une ligne à retard (8), un amplificateur à commande automatique de gain 12 et un déphaseur réglable (13), le retard entre l'entrée de ce circuit et sa sortie étant égal à un nombre entier de période du signal d'horloge, la commande de décalage de la ligne à retard (8) étant commandée par un oscillateur (9) asservi en phase à partir d'un comparateur de phase (15) dont les entrées sont connectées à l'entrée et à la sortie du circuit de sortie (40).

3/ Dispositif selon la revendication 2, caractérisé en ce que l'oscillateur (9) est commandé par un varactor (93) ayant une forte résistance interne, et en ce que la boucle de phase comporte un filtre de boucle (11) avec un condensateur de forte valeur (C) qui se décharge lentement à travers le varactor lors des coupures de transmission, le signal de commande de décalage de la ligne à retard (8) ne dérivant que d'une fraction de période d'horloge lors de coupures de l'ordre d'une seconde.

4/ Dispositif selon l'une des revendications 2 et 3, caractérisé en ce que la ligne à retard (8) est une ligne à transfert de charges.

5/ Dispositif selon l'une des revendications précédentes, caractérisé en ce que le circuit de commutation comporte un circuit logique de commande (7) recevant un signal caractéristique du bruit de la liaison et délivrant un signal à deux états, et un commutateur à deux positions commandé par le signal à deux états.

**Claims**

1. A clock-frequency recovery device suited to high-frequency radiocommunications in disturbed media and comprising an analog circuit (10) for rectifying the received signal in order to render apparent in the signal a component at the clock frequency, the output of said analog circuit being connected to a filter circuit (20), a switching circuit (30) having two positions as a function of the quality of the transmission, and an output circuit (40) at the output of which the recovered clock signal is available, the switching circuit (30) connecting the input of said output circuit (40) to the output of said filter circuit (20) whenever the transmission is of good quality, characterized in that the filter circuit (20) has a very narrow bandwidth and that the switching circuit (30) connects the input of the output circuit to its own output whenever the transmission has a high noise level, the shift between the input and the output of said output circuit being adjusted so as to be equal to an integer number of periods of the clock signal.

2. A device according to claim 1, characterized in that the output circuit (40) comprises in series a delay line (8), an amplifier providing automatic gain control (12) and an adjustable phase shifter, the time-delay between the input of said circuit and its output being equal to an integer number of periods of the clock signal, the shift control of the delay line (8) being carried out by an oscillator (9) which is phase-controlled by a phase comparator (15) whose inputs are connected to the input and to the output of the output circuit (40).

3. A device according to claim 2, characterized in that the oscillator (9) is controlled by a varactor (93) having a high internal resistance, and that the phase loop comprises a loop filter (11) with a high-value capacitor which discharges slowly through the varactor during interruptions in transmission, the signal for the shift control of the delay-line (8) drifting only a fraction of the clock period during transmission interruptions of about one second.

4. A device according to one of claims 2 and 3, characterized in that the delay line (8) is a charge transfer line.

5. A device according to one of the preceding claims, characterized in that the switching circuit comprises a logic control circuit (7) receiving a signal which is characteristic of the noise of the transmission and delivering a binary signal, and a two-position switch controlled by said binary signal.

**Patentansprüche**

1. Schaltungsanordnung zur Wiedergewinnung der Taktfrequenz aus hochfrequenten Funksignalen in gestörtem Umfeld, mit einem analogen Gleichrichterkreis (10) für das empfangene Signal, um im Signal eine Komponente mit Taktfrequenz deutlich werden zu lassen, wobei der Ausgang dieses Kreises an einen Filterkreis (20) angeschlossen ist, mit einem Umschaltkreis (30), der zwei Stellungen in Abhängigkeit von der Qualität der Verbindung besitzt, und mit einem Ausgangskreis (40), an dessen Ausgang das wiedergewonnene Taktsignal verfügbar ist, wobei der Umschaltkreis (30) den Eingang des Ausgangskreises (40) mit dem Ausgang des Filterkreises (20) verbindet, wenn die Funkverbindung von guter Qualität ist, dadurch gekennzeichnet, daß der Filterkreis (20) ein Kreis mit sehr geringer Sandbreite ist und daß der Umschaltkreis (30) den Eingang des Ausgangskreises mit seinem eigenen Ausgang verbindet, wenn die Verbindung einen hohen Geräuschpegel hat, wobei die Zeitverzögerung zwischen dem Eingang und dem Ausgang des Ausgangskreises so eingestellt wird, daß sie gleich einer ganzen Anzahl von Perioden des Taktsignals ist.

2. Schaltungsanordnung nach Anspruch 1, dadurch gekennzeichnet, daß der Ausgangskreis (40) in Serie eine Verzögerungsleitung (8), einen Verstärker (12) mit automatischer Verstärkungssteuerung und einen regelbaren Phasenschieber (13) aufweist, wobei die Verzögerung zwischen dem Eingang dieses Kreises und seinem Ausgang gleich einer ganzen Anzahl von Perioden des Taktsignals ist und die Verzögerungssteuerung der Verzögerungsleitung (8) von einem phasengeregelten Oszillator (9)

**0 099 814**

ausgehend von einem Phasenkomparator (15) gesteuert wird, dessen Eingänge an den Eingang und den Ausgangs des Ausgangskreises (40) angeschlossen sind.

3. Schaltungsanordnung nach Anspruch 2, dadurch gekennzeichnet, daß der Oszillator (9) von einem Varactor (93) mit hohem Innenwiderstand gesteuert wird und daß die Phasenschleife ein Schleifenfilter (11) mit einem Kondensator großer Kapazität (C) enthält, der sich langsam über den Varactor während der Unterbrechungen der Übertragung entlädt, wobei das Steuersignal für die Verzögerung der Verzögerungsleitung (8) nur um einen Bruchteil einer Taktperiode abweicht, wenn die Unterbrechungen in der Größenordnung einer Sekunde bleiben.

4. Schaltungsanordnung nach einem der Ansprüche 2 und 3, dadurch gekennzeichnet, daß die Verzögerungsleitung (8) eine Leitung vom Ladungstransfertyp ist.

5. Schaltungsanordnung nach einem der vorhergehenden Ansprüche, dadurch gekennzeichnet, daß der Umschaltkreis einen logischen Steuerkreis (7), der ein für den Rauschpegel der Verbindung charakteristisches Signal empfängt und ein binäres Signal abgibt, und einen Umschalter mit zwei Schaltstellungen enthält, der von dem binären Signal gesteuert wird.

Fig.1

Fig.2